# Europäisches Patentamt
# European Patent Office
# Office européen des brevets

(11) Veröffentlichungsnummer: **0 356 549 B1**

(12) **EUROPÄISCHE PATENTSCHRIFT**

(45) Veröffentlichungstag der Patentschrift: **10.03.93**

(51) Int. Cl.⁵: **H04L 7/02**, H03L 7/08

(21) Anmeldenummer: **88114140.2**

(22) Anmeldetag: **30.08.88**

(54) Verfahren und Schaltungsanordnung für eine digitale Regelung der Phase von Abtasttaktimpulsen.

(43) Veröffentlichungstag der Anmeldung:
**07.03.90 Patentblatt 90/10**

(45) Bekanntmachung des Hinweises auf die Patenterteilung:
**10.03.93 Patentblatt 93/10**

(84) Benannte Vertragsstaaten:
**AT BE CH DE FR GB IT LI NL SE**

(56) Entgegenhaltungen:
**DE-A- 3 532 857**

(73) Patentinhaber: **SIEMENS AKTIENGESELL-SCHAFT**
**Wittelsbacherplatz 2**
**W-8000 München 2(DE)**

(72) Erfinder: **Schenk, Heinrich, Dr. Ing.**
**Becker-Gundahl-Strasse 1**
**W-8000 München 71(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3. 10/3.5x/3.0. 1)

**Beschreibung**

Die Erfindung betrifft ein Verfahren und eine Schaltungsanordnung gemäß Oberbegriff des Patentanspruchs 1.

Es ist bereits ein Verfahren für eine digitale Regelung der Phase von Abtasttaktimpulsen in einer Teilnehmeranschlußschaltung eines diensteintegrierenden Digitalnetzes bekannt ("telcom report", 8 (1985), Sonderheft "Diensteintegrierendes Digitalnetz ISDN"; " Die Teilnehmersclußtechnik im ISDN" Gero Schollmeier.). Bei dieser bekannten Teilnehmeranschlußschaltung werden einer Empfangseinrichtung zu durch das Auftreten der Abtasttaktimpulse festgelegten Zeitabständen Abtastproben in analoger Form empfangener Digitalsignale nach einer Analog-Digital-Wandlung für eine Umsetzung der empfangenen Digitalsignale zugeführt. Aus den empfangenen Digitalsignalen werden mit Hilfe einer Taktregelung und einer Takterzeugung, auf deren schaltungstechnische Realisierung nicht eingegangen wird, die genannten Abtasttaktimpulse abgeleitet.

Darüber hinaus ist es bereits bekannt ("Unterrichtsblätter der Deutschen Bundespost", Jahrgang 34/1981, Nr.2, Seiten 75-83), in digitalen Übertragungssystemen für eine Taktrückgewinnung Phasenregelkreise mit einem Schleifenfilter in Form eines Tiefpasses geringer Bandbreite vorzusehen, um Phasenschwankungen (Phasenjitter) des Leitungssignals, die durch die Übertragungsstrecke hervorgerufen sind, zu unterdrücken. Auf die Realisierung eines derartigen Schleifenfilters wird jedoch nicht eingegangen.

Es ist nun Aufgabe der vorliegenden Erfindung, einen Weg zu zeigen, wie bei einem Verfahren und einer Schaltungsanordnung gemäß Oberbegriff des Patentanspruches 1 in einfacher Weise eine Filterung der für eine Phasenregelung von Abtasttaktimpulsen vorgesehenen Phasenregelsignale vorgenommen werden kann.

Gelöst wird die vorstehend aufgezeigte Aufgabe bei einem Verfahren gemäß Oberbegriff des Patentanspruches 1 durch die im kennzeichnenden Teil des Patentanspruches 1 angegebenen Merkmale. Diese Art der Filterung läßt sich vorteilhaft immer dann anwenden, wenn in einer die Digitalsignale abgebenden Sendeeinrichtung und der mit dieser zusammenarbeitenden Empfangseinrichtung Taktimpulse gleicher Frequenz, beispielsweise unter der Steuerung eines extern zugeführten Mastertaktes, zur Verfügung stehen und in der Empfangseinrichtung lediglich eine Phasenregelung vorzunehmen ist.

Eine besonders günstige Realisierung der Filterung wird durch die im Patentanspruch 2 angegebene Festlegung der Filterkoeffizienten erreicht.

Darüber hinaus ist es zweckmäßig, die Quantisierung eines gefilterten Phasenregelsignals variabel gemäß Patentanspruch 3 durchzuführen. Durch diese variable Quantisierung wird erreicht, daß im eingeschwungenen Zustand gefilterte Phasenregelsignale mit einem Wert "0" bereitgestellt werden, so daß in diesem Zustand keine Veränderung des Taktgenerators vorgenommen wird.

Das Verfahren kann auch noch in der Weise ausgebildet sein, daß die Anzahl der in einem vorgegebenen Zeitintervall an den Taktgenerator abgegebenen Phasenregelsignale gegenüber der Anzahl der quantisierten gefilterten Phasenregelsignale reduziert ist. Durch diese Reduzierung ist es beispielsweise möglich, in einer Digitalsignal-Empfangseinrichtung, welche von einem Echokompensator her Kompensationssignale zugeführt erhält, die Regelgeschwindigkeit des Taktregelkreises an die Regelgeschwindigkeit des Echokompensators anzupassen.

Eine Schaltungsanordnung zur Durchführung des Verfahrens gemäß der vorliegenden Erfindung sowie vorteilhafte Ausgestaltungen ergeben sich aus den Patentansprüchen 5 und 7.

Der Vorteil dieser Schaltungsanordnung besteht in dem geringen schaltungstechnischen Aufwand für die Realisierung der Filteranordnung und des mit dieser verbundenen Quantisierers.

Im folgenden wird nun die vorliegende Erfindung anhand von Zeichnungen näher erläutert.

Figur 1 zeigt eine Digitalsignal-Empfangseinrichtung, bei der die vorliegende Erfindung angewandt ist , und

Figur 2 zeigt den Aufbau der in Figur 1 lediglich schematisch dargestellten Filteranordnung und des dieser nachgeschalteten Quantisierers.

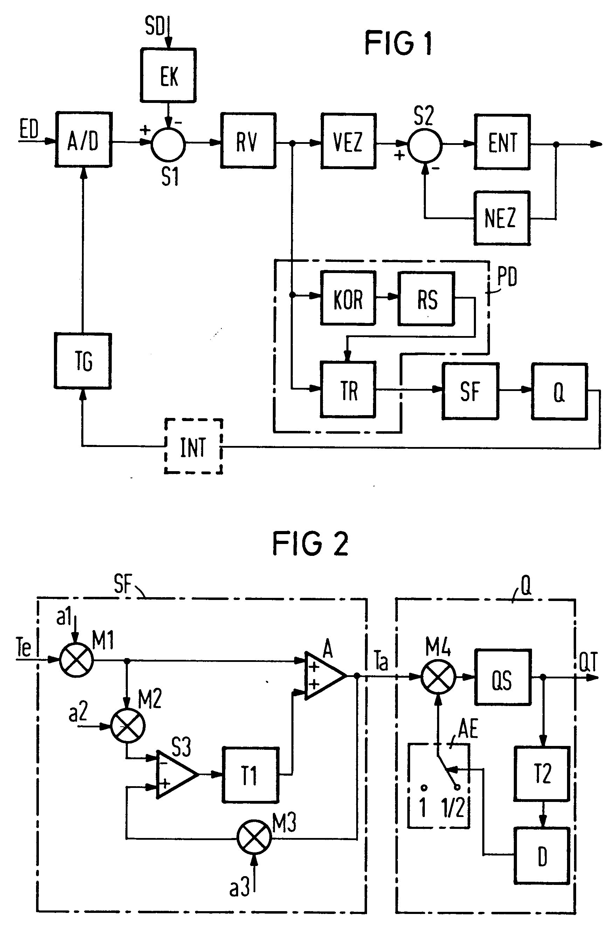

Die in Figur 1 dargestellte Digitalsignal-Empfangseinrichtung stellt in schematischer Form den Empfänger einer Teilnehmeranschlußschaltung für das diensteintegrierende Digitalnetz ISDN dar. Die Teilnehmeranschlußschaltung möge dabei für eine Duplexübertragung von Digitalsignalen über eine Zweidraht-Leitung im Gleichlage-Verfahren ausgelegt sein. Von einer solchen Teilnehmeranschlußschaltung werden beispielsweise als Nachrichtensignale über die Zweidraht-Leitung zu übertragende Binärsignale zunächst in mehrstufige Signale, beispielsweise dreistufige Signale, umgesetzt und nach einer Impulsformung als analoge Signale in einem Datenblock über eine Gabelanordnung abgegeben. In einem solchen Datenblock, der beispielsweise 120 Bit umfassen möge, ist zusätzlich zu den Nachrichtensignalen eine Synchronisierinformation enthalten. Als Synchronisierinformation ist bei dem vorliegenden Ausführungsbeispiel ein Barker-Code mit einer Länge von 11 Bit gewählt.

Von der betreffenden Teilnehmeranschlußschaltung über die Zweidraht-Leitung aufzunehmende analoge Signale durchlaufen zunächst die bereits erwähnte Gabelanordnung und gelangen anschließend zu der in Figur 1 dargestellten Digitalsignal-Empfangseinrichtung. Den Eingang dieser Empfangseinrichtung bildet ein Analog-Digital-Wandler A/D, der den ihm zugeführten analogen Signalen Abtastproben beispielsweise in einem einer Bitlänge der in einem Datenblock übertragenen Signale entsprechenden Abstand entnimmt und diese jeweils in ein 16-Bit-Digitalsignal umsetzt. Die dafür erforderlichen Abtasttaktimpulse werden von einem regelbaren Taktgenerator TG bereitgestellt.

Die 16-Bit-Digitalsignale werden anschließend nacheinander einem Subtrahierer S1 zugeführt, der gleichzeitig mit Kompensationssignalen von einem Echokompensator EK her beaufschlagt ist. Durch diese Kompensationssignale werden in den 16-Bit-Digitalsignalen enthaltene Echosignalanteile kompensiert, die bei der zuvor beschriebenen Abgabe von Datenblöcken über die Zweidraht-Leitung durch Reflexionen auf dieser Leitung beziehungsweise durch eine nicht vollständige Entkopplung der Übertragungswege der Gabelanordnung den empfangenen analogen Signalen überlagert sind.

Die kompensierten Digitalsignale werden anschließend für eine weitere Verarbeitung über einen Regelverstärker RV und eine Entzerrer-Anordnung weitergeleitet, die die durch die elektrischen Eigenschaften der Zweidraht-Leitung bedingten Verzerrungen weitgehend beseitigt. Die Entzerrer-Anordnung weist dabei beispielsweise einen Vorschwinger-Entzerrer VEZ auf, dessen Ausgangssignale einem Subtrahierer S2 zugeführt sind. Ein zweiter Eingang dieses Subtrahierers ist mit dem Ausgang eines Nachschwinger-Entzerrers NEZ verbunden. Eingangsseitig ist dieser Entzerrer an dem Ausgang eines Entscheiders ENT angeschlossen, der dem Subtrahierer S2 nachgeschaltet ist.

Auf die zuvor genannten Schaltungsteile der in Figur 1 dargestellten Digitalsignal-Empfangseinrichtung wird im folgenden nicht näher eingegangen, da deren Wirkungsweise bereits hinlänglich bekannt ist.

Mit dem Ausgang des zuvor genannten Regelverstärkers RV ist ein Phasendiskriminator PD verbunden, der aus den ihm zugeführten Signalen Phasenregelsignale ableitet, die proportional zu der gerade bestehenden Regelabweichung sind. Bei dem vorliegenden Ausführungsbeispiel weist der Phasendiskriminator einen Korrelator KOR auf, der eingangsseitig mit dem Ausgang des Regelverstärkers RV und ausgangsseitig mit einer Rahmensynchronisier-Einrichtung RS verbunden ist. Mit Hilfe dieser beiden Einrichtungen werden aus den am Ausgang des Regelverstärkers RV auftretenden Signalen Rahmentaktimpulse gewonnen, die zusammen mit den am Ausgang des Regelverstärkers auftretenden Signalen einer Taktregeleinrichtung TR zugeführt sind. Diese Taktregeleinrichtung leitet daraus während des Empfangs der oben erwähnten Synchronisierinformation der jeweils gerade vorliegenden Regelabweichung proportionale Phasenregelsignale ab.

Bezüglich des Phasendiskriminators PD sei noch darauf hingewiesen, daß zwar vorstehend eine mögliche Ausführungsform beschrieben ist. Die Ausführungsform ist jedoch nicht wesentlich für die vorliegende Erfindung. Vielmehr wird lediglich vorausgesetzt, daß der Phasendiskriminator aus den ihm zugeführten Signalen Phasenregelsignale ableitet, die proportional zu den vorliegenden Regelabweichungen sind. So wäre es beispielsweise auch möglich, daß der Phasendiskriminator bei einer Nachrichtensignalübertragung über eine Zweidraht-Leitung ohne Synchronisierinformation die Phasenregelsignale direkt aus den empfangenen Nachrichtensignalen ableitet.

Die von dem Phasendiskriminator PD abgegebenen Phasenregelsignale weisen im allgemeinen Rauschanteile auf. Für die Unterdrückung dieser Rauschanteile und damit für das Erreichen eines geringen Phasenjitters durchlaufen die Phasenregelsignale ein schmalbandiges Schleifenfilter SF. Die gefilterten Phasenregelsignale werden anschließend einem Quantisierer Q zugeführt, der an seinem Ausgang jeweils 4 Bit umfassende quantisierte Phasenregelsignale bereitstellt, mit denen der bereits genannte regelbare Taktgenerator TG für eine Regelung der Phase der Abtasttaktimpulse beaufschlagt ist. Der Taktgenerator möge dafür beispielsweise einen durch die zugeführten Phasenregelsignale einstellbaren Taktteiler aufweisen.

Figur 2 zeigt den möglichen Aufbau des gerade genannten Schleifenfilters SF und des diesem nachgeschalteten Quantisierers Q. Das Schleifenfilter weist eingangsseitig einen Multiplizierer M1 auf, dem die von dem Phasendiskriminator PD abgegebenen Phasenregelsignale Te und ein konstanter Filterkoeffizient a1 zugeführt sind. Das daraus resultierende Produktsignal gelangt einerseits an einen ersten Eingang eines Addierers A und andererseits an einen Eingang eines Multiplizierers M2, welcher an einem zweiten Eingang einen konstanten Filterkoeffizienten a2 zugeführt erhält.

Das Ausgangssignal dieses Multiplizierers wird an einen Eingang (-) eines Subtrahierers S3 weitergeleitet. Ein weiterer Eingang dieses Subtrahierers ist an den Ausgang eines Multiplizierers M3 angeschlossen, an dessen zwei Eingängen ein konstanter Filterkoeffizient a3 und das Ausgangssignal des bereits genannten Addierers A anliegen.

Der Ausgang des Subtrahierers S3 wird über ein Verzögerungsglied T1, dessen Zeitkonstante dem zeitlichen Abstand zweier aufeinanderfolgender Phasenregelsignale entspricht, einem zweiten Eingang des Addierers A zugeführt.

Das gerade beschriebene Schleifenfilter liefert an seinem Ausgang Phasenregelsignale in der Form

$$Ta(i) = a1(Te(i)-a2Te(i-1)) + a3Ta(i-1).$$

Dabei bedeuten a1,a2 und a3 die zuvor genannten Filterkoeffizienten, Ta(i) und Ta(i-1) am Ausgang des Schleifenfilters auftretende Phasenregelsignale zu den Zeitpunkten i und (i-1) und Te(i) und Te(i-1) zu den Zeitpunkten i und (i-1) von dem Phasendiskriminator PD bereitgestellte Phasenregelsignale. Eine günstige Realisierung des Schleifenfilters ergibt sich, wenn die Filterkoeffizienten in folgender Form gewählt sind:
$a1 = 2^{-L1}$
$a2 = 1-2^{-L2}$
$a3 = 1-2^{-L3}$.

L1,L2 und L3 sind dabei ganzzahlig. Beispielsweise kann L2 = 4 und L3 = 6 festgelegt sein. L1 hängt von der Skalierung der von dem Phasendiskriminator PD abgegebenen Phasenregelsignale ab.

Die von dem Schleifenfilter SF abgegebenen gefilterten Phasenregelsignale werden einem Multiplizierer M4 des Quantisierers Q zugeführt. Ein weiterer Eingang dieses Multiplizierers ist mit dem Ausgang einer steuerbaren Auswahleinrichtung AE verbunden. Diese Auswahleinrichtung gibt wahlweise zwei unterschiedliche Konstanten ab, mit denen die gefilterten Phasenregelsignale multipliziert werden. Bei dem vorliegenden Ausführungsbeispiel sind die Konstanten mit 1 und 0,5 festgelegt.

Der Ausgang des Multiplizierers M4 ist mit einer Quantisierungsstufe QS verbunden, welche jeweils 4 Bit umfassende quantisierte Phasenregelsignale QT abgibt. Diese werden einerseits, wie bereits vorstehend erläutert, dem Taktgenerator TG und andererseits einem Verzögerungsglied T2 zugeführt. Dessen Zeitkonstante entspricht dabei dem zeitlichen Abstand zweier aufeinander folgender quantisierter Phasenregelsignale. Der Ausgang dieses Verzögerungsgliedes ist mit einem Diskriminator D verbunden, der ein Steuersignal abgibt, dessen Pegel anzeigt, ob das am Ausgang des Verzögerungsgliedes T2 auftretende Phasenregelsignal einen Wert "0" oder einen davon abweichenden Wert aufweist. Mit diesem Steuersignal wird die Auswahl einer der beiden Konstanten in der Auswahleinrichtung AE gesteuert. Die Steuerung erfolgt dabei in der Weise, daß bei einem zum Zeitpunkt (i-1) am Ausgang der Quantisierungsstufe QS auftretenden quantisierten Phasenregelsignal mit einem Wert "0" die Konstante 0,5 zum Zeitpunkt i bereit gestellt ist. Bei einem von "0" abweichenden Wert wird dagegen die Konstante 1 ausgewählt. Der Quantisierer Q weist somit ein Hysterese-Verhalten auf, durch welches im eingeschwungenen Zustand des Phasenregelkreises am Ausgang des Quantisierers der Wert "0" anliegt. Daraus resultiert, daß der bereits erwähnte Taktteiler des Taktgenerators TG in diesem eingeschwungenen Zustand unverändert bleibt und damit ein Phasenjitter vermieden wird.

Die anhand der Figur 1 beschriebene Digitalsignal-Empfangseinrichtung kann auch in der Weise ausgebildet sein, daß, wie in Figur 1 angedeutet ist, zwischen dem Quantisierer Q und dem Taktgenerator TG eine Geschwindigkeits-Anpassungseinrichtung INT geschaltet ist. Damit kann die Regelgeschwindigkeit des Taktregelkreises beispielsweise für eine Anpassung an die Regelgeschwindigkeit des Echokompensators EK reduziert werden. Die Anpassungseinrichtung kann dabei aus einer Integratoranordnung, beispielsweise in Form einer rücksetzbaren Zähleranordnung oder einer Ringzähleranordnung, gebildet sein, welche die ihr zugeführten quantisierten Phasenregelsignale integriert und erst bei Überschreiten eines vorgegebenen Schwellwertes ein Phasenregelsignal an den Taktgenerator TG abgibt. Eine weitere Möglichkeit besteht in der Verwendung einer Zähleranordnung, welche erst bei Vorliegen einer vorgegebenen Anzahl von quantisierten Phasenregelsignalen und bei Überschreiten eines vorgegebenen Schwellwertes durch diese Phasenregelsignale ein Phasenregelsignal für den Taktgenerator TG bereitstellt.

Abschließend sei noch darauf hingewiesen, daß zwar vorstehend die vorliegende Erfindung am Beispiel einer Digitalsignal-Empfangseinrichtung für den Empfang von Digitalsignalen über eine Zweidraht-Leitung beschrieben worden ist. Die Erfindung ist jedoch allgemein immer dann einsetzbar, wenn in einer Digitalsignal-Empfangseinrichtung mit Hilfe eines Phasenregelkreises anhand der empfangenen Signale eine Regelung der Phase von Abtasttaktimpulsen durchzuführen ist.

## Patentansprüche

1. Verfahren für eine digitale Regelung der Phase von Abtasttaktimpulsen in einer Digitalsignal-Empfangseinrichtung, welcher zu durch das Auftreten der Abtasttaktimpulse festgelegten Zeitabständen Abtastproben in analoger Form empfangener Digitalsignale nach einer Analog-Digital-Wandlung für eine Umsetzung der empfangenen Digitalsignale zugeführt werden und in welcher aus den empfangenen Digitalsignalen abgeleitete Phasenregelsignale bereitgestellt werden, die nach einer Filterung in vorgegebenen Zeitabständen einem Taktgenerator für die Abgabe der Abtasttaktimpulse zugeführt werden, **dadurch gekennzeichnet**, daß die Filterung der Phasenregelsignale in der Form

$$Ta(i) = a1(Te(i) - a2\ Te(i-1)) + a3\ Ta(i-1)$$

durchgeführt wird, wobei a1, a2, a3 Filterkoeffizienten, Ta(i) und Ta(i-1) gefilterte Phasenregelsignale zu den Zeitpunkten i und (i-1) und Te(i) und Te(i-1) zu den Zeitpunkten i und (i-1) bereitgestellte Phasenregelsignale darstellen, und daß die gefilterten Phasenregelsignale in quantisierter Form dem Taktgenerator zugeführt werden.

2. Verfahren nach Anspruch 1, **dadurch gekennzeichnet**, daß die Filterkoeffizienten mit $a1 = 2^{-L1}$, $a2 = (1-2^{-L2})$ und $a3 = (1-2^{-L3})$ festgelegt werden, wobei L1, L2 und L3 ganzzahlig sind.

3. Verfahren nach Anspruch 1 oder 2, **dadurch gekennzeichnet**, daß die Quantisierung eines gefilterten Phasenregelsignals zum Zeitpunkt i nach Maßgabe des zu dem Zeitpunkt (i-1) an den Taktgenerator abgegebenen quantisierten Phasenregelsignals durchgeführt wird.

4. Verfahren nach einem der Ansprüche 1 bis 3, **dadurch gekennzeichnet**, daß die Anzahl der in einem vorgegebenen Zeitintervall an den Taktgenerator abgegebenen Phasenregelsignale gegenüber den quantisierten gefilterten Phasenregelsignalen reduziert ist.

5. Schaltungsanordnung zur Durchführung des Verfahrens nach Anspruch 1 oder 2, mit einer Digitalsignal-Empfangseinrichtung, welcher ein aus einem Phasendiskriminator (PD) und einem durch diesen regelbaren Taktgenerator (TG) bestehender Taktregelkreis zugehörig ist, wobei der Phasendiskriminator mit den Abtastproben empfangener Digitalsignale beaufschlagt ist und aus den Abtastproben Phasenregelsignale ableitet, die dem Taktgenerator in vorgegebenen Zeitabständen über eine Filteranordnung (SF) zugeführt sind, **dadurch gekennzeichnet**, daß die Filteranordnung (SF) Phasenregelsignale in der Form

$$Ta(i) = a1(Te(i) - a2\ Te(i-1)) + a3\ Ta(i-1)$$

bereitstellt, wobei a1, a2, a3 Filterkoeffizienten, Ta(i) und Ta(i-1) gefilterte Phasenregelsignale zu den Zeitpunkten i und (i-1) und Te(i) und Te(i-1) zu den Zeitpunkten i und (i-1) von dem Phasendiskriminator (PD) her bereitgestellte Phasenregelsignale darstellen, und daß die gefilterten Phasenregelsignale dem Taktgenerator (TG) über einen Quantisierer (Q) zugeführt sind.

6. Schaltungsanordnung nach Anspruch 5, **dadurch gekennzeichnet**, daß der Quantisierer (Q) eingangsseitig einen Multiplizierer (M4) mit zwei Eingängen aufweist, dessen einem Eingang die gefilterten Phasenregelsignale zugeführt sind und dessen anderer Eingang mit einer steuerbaren Auswahleinrichtung (AE) verbunden ist, welche wahlweise eine von zwei vorgegebenen Konstanten bereitstellt, und daß die Auswahleinrichtung von einer eingangsseitig mit dem Ausgang des Quantisierers verbundenen Steuereinrichtung (T2, D) derart steuerbar ist, daß die Auswahleinrichtung bei einem am Ausgang des Quantisierers zum Zeitpunkt (i-1) auftretenden Phasenregelsignal mit einem Wert "0" zum Zeitpunkt i die niedrigere der beiden Konstanten, bei einem von "0" abweichenden Wert dagegen die höhere der beiden Konstanten bereitstellt.

7. Schaltungsanordnung nach Anspruch 5 oder 6, **dadurch gekennzeichnet**, daß zwischen dem Quantisierer (Q) und dem Taktgenerator (TG) eine Geschwindigkeits-Anpassungseinrichtung (INT) geschaltet ist, welche in einem vorgegebenen Zeitintervall lediglich eine gegenüber der Anzahl der von dem Quantisierer bereitgestellten Phasenregelsignale reduzierte Anzahl von Phasenregelsignalen an den Taktgenerator abgibt.

**Claims**

1. Method for a digital control of the phase of sampling clock pulses in a digital signal receiving device, to which samples of digital signals received in analog form are supplied, after an analog-digital conversion, at time intervals defined by the occurrence of the sampling clock pulses for a conversion of the received digital signals, and in which phase control signals derived from the received digital signals are provided which, after a filtering at given time intervals, are supplied to a clock generator for the output of the sampling clock pulses, characterised in that the filtering of the phase control signals is performed in the form

$$Ta(i) = a1(Te(i) - a2\ Te(i-1)) + a3\ Ta(i-1),$$

where a1, a2, a3 represent filter coefficients, Ta(i) and Ta(i-1) represent filtered phase control signals at the instants i and (i-1), and Te(i) and Te(i-1) represent phase control signals provided at the instants i and (i-1), and in that the filtered phase control signals are supplied to the clock generator in quantised form.

2. Method according to Claim 1, characterised in that the filter coefficients are defined with a1 = $2^{-L1}$, a2 = $(1-2^{-L2})$ and a3 = $(1-2^{-L3})$, where L1, L2 and L3 are integers.

3. Method according to Claim 1 or 2, characterised in that the quantisation of a filtered phase control signal is performed at the instant i in accordance with the quantised phase control signal output to the clock generator at the instant (i-1).

4. Method according to one of Claims 1 to 3, characterised in that the number of phase control signals output to the clock generator in a given time interval is reduced in comparison with the quantised filtered phase control signals.

5. Circuit arrangement for carrying out the method according to Claim 1 or 2, having a digital signal receiving device which contains a clock control circuit comprising a phase discriminator (PD) and a clock generator (TG) that can be controlled by the latter, in which the phase discriminator receives the samples of received digital signals and from the samples derives phase control signals which are supplied to the clock generator via a filter arrangement (SF) at given time intervals, characterised in that the filter arrangement (SF) provides phase control signals in the form

Ta(i) = a1(Te(i) - a2 Te(i-1)) + a3 Ta(i-1),

where a1, a2, a3 represent filter coefficients, Ta(i) and Ta(i-1) represent filtered phase control signals at the instants i and (i-1), and Te(i) and Te(i-1) represent phase control signals provided by the phase discriminator (PD) at the instants i and (i-1), and in that the filtered phase control signals are supplied to the clock generator (TG) via a quantiser (Q).

6. Circuit arrangement according to Claim 5, characterised in that the quantiser (Q) has on the input side a multiplier (M4) with two inputs, to one input of which the filtered phase control signals are supplied and the other input of which is connected to a controllable selection device (AE) which provides optionally one of two given constants, and in that the selection device can be controlled by a control device (T2, D) connected on the input side to the output of the quantiser in such a way that, given a phase control signal occurring at the output of the quantiser at the instant (i-1) with a value "0" at the instant i, the selection device provides the lower of the two constants, and on the other hand provides the higher of the two constants given a value deviating from "0".

7. Circuit arrangement according to Claim 5 or 6, characterised in that connected between the quantiser (Q) and the clock generator (TG) is a speed adjusting device (INT) which in a given time interval outputs only a reduced number of phase control signals to the clock generator in comparison with the number of phase control signals provided by the quantiser.

**Revendications**

1. Procédé de régulation numérique de la phase d'impulsions de cadence d'échantillonnage dans un dispositif de réception de signaux numériques, auquel des échantillons sont envoyés, sous la forme analogique de signaux numériques reçus, à des intervalles de temps fixés par l'apparition d'impulsions de cadence d'échantillonnage, après une conversion analogique/numérique pour une conversion des signaux numériques reçus et dans lequel sont préparés des signaux de régulation de phase, qui sont tirés des signaux numériques reçus et sont envoyés, après un filtrage, à des intervalles de temps prédéterminés, à un générateur de cadence pour la délivrance des impulsions de cadence d'échantillonnage, caractérisé par le fait que le filtrage des signaux de régulation de phase est exécuté sous la forme

Ta(i) = a1 (Te(i) - a2 Te(i-1)) + a3 Ta(i-1)

a1, a2, a3 étant des coefficients du filtre, Ta(i) et Ta(i-1) étant des signaux filtrés de régulation de phase apparaissant aux instants i et (i-1), et Te(i) et Te(i-1) représentant des signaux de régulation de phase préparés aux instants i et (i-1), et
que les signaux filtrés de régulation de phase sont envoyés sous forme quantifiée au générateur de cadence.

2. Procédé suivant la revendication 1, caractérisé par le fait que les coefficients du filtre sont déterminés par a1 = $2^{-L1}$, a2 = $(1-2^{-L2})$, et a3 = $(1-2^{-L3})$, L1, L2 et L3 étant des nombres entiers.

3. Procédé suivant la revendication 1 ou 2, caractérisé par le fait que la quantification d'un signal filtré de régulation de phase est exécutée à l'instant i en fonction du signal de régulation de phase quantifié, envoyé à l'instant (i-1) au générateur de cadence.

4. Procédé suivant l'une des revendications 1 à 3, caractérisé par le fait que le nombre des signaux de régulation de phase délivrés pendant un intervalle de temps prédéterminé au générateur de cadence est réduit par rapport aux signaux de régulation de phase filtrés et quantifiés.

5. Montage pour la mise en oeuvre du procédé suivant la revendication 1 ou 2, comportant un dispositif de réception de signaux numériques, auquel est associé un circuit de régulation de la cadence, qui est constitué par un discriminateur de phase (PD) et par un générateur de cadence (TG) réglable au moyen de ce discriminateur, et dans lequel le discriminateur de phase est chargé par des échantillons de signaux numériques reçus, alors qu'à partir des échantillons sont dérivés, des signaux de régulation de phase, qui sont envoyés au générateur de cadence, par l'intermédiaire d'un dispositif de filtre (SF), à des intervalles de temps prédéterminés, au générateur de cadence, caractérisé par le fait
que le dispositif de filtre (SF) prépare des signaux de régulation de phase de la forme

$$Ta(i) = a1(Te(i) - a2\, Te(i-1)) + a3\, Ta(i-1)$$

a1, a2, a3 étant des coefficients de filtre, Ta(i) et Ta(i-1) étant des signaux filtrés de régulation de phase apparaissant aux instants i et (i-1), et Te(i) et Te(i-1) représentant des signaux de régulation de phase préparés aux instants i et (i-1), à partir du discriminateur de phase (PD), et
que les signaux filtrés de régulation de phase sont envoyés au générateur de cadence (TG), par l'intermédiaire d'un quantificateur (Q).

6. Montage suivant la revendication 5, caractérisé par le fait
que le quantificateur (Q) comporte, côté entrée, un multiplicateur (M4) à deux entrées, à l'une desquelles sont envoyés les signaux de régulation de phase filtrés et dont l'autre est raccordée à un dispositif de sélection commandable (AE), qui prépare, au choix, l'une de deux constantes prédéterminée, et que le dispositif de sélection peut être commandé par un dispositif de commande (T2, D) raccordé côté entrée à la sortie du quantificateur de sorte que pour un signal de régulation de phase apparaissant à la sortie du quantificateur à l'instant (i-1), le dispositif de sélection prépare avec une valeur "0" à l'instant i la plus faible des deux constantes et au contraire, pour une valeur différente de "0", la plus grande des deux constantes.

7. Montage suivant la revendication 5 ou 6, caractérisé par le fait qu'entre le quantificateur (Q) et le générateur de cadence (TG) est branché un dispositif d'adaptation de vitesse (INT), qui, dans un intervalle de temps prédéterminé, envoie au générateur de cadence seulement un nombre de signaux de régulation de phase qui est réduit par rapport au nombre des signaux de régulation de phase préparés par le quantificateur.

# FIG 1

# FIG 2